(19) Europäisches Patentamt
European Patent Office
Office européen des brevets

(11) **EP 3 051 392 B1**

(12) **EUROPEAN PATENT SPECIFICATION**

(45) Date of publication and mention
of the grant of the patent:
**14.11.2018 Bulletin 2018/46**

(21) Application number: **14849651.6**

(22) Date of filing: **21.07.2014**

(51) Int Cl.:
***G06F 3/041*** (2006.01)      ***B32B 37/26*** (2006.01)
***B32B 38/00*** (2006.01)

(86) International application number:
**PCT/CN2014/082576**

(87) International publication number:
**WO 2015/043297 (02.04.2015 Gazette 2015/13)**

(54) **TOUCH PANEL MANUFACTURING METHOD**

BERÜHRUNGSTAFELHERSTELLUNGSVERFAHREN

PROCÉDÉ DE FABRICATION DE PANNEAU TACTILE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.09.2013 CN 201310454870
04.06.2014 CN 201410243785
04.06.2014 CN 201410244190**

(43) Date of publication of application:
**03.08.2016 Bulletin 2016/31**

(73) Proprietor: **TPK Touch Solutions (Xiamen) Inc.**
**Xiamen, Fujian 361009 (CN)**

(72) Inventors:
 • **LIN, Chingshan**
   **Kaohsiung 804 (TW)**
 • **WU, Chunyan**
   **Sanming**
   **Fujian 365116 (CN)**
 • **JI, Lianjie**
   **Xiamen**
   **Fujian 361004 (CN)**
 • **FANG, Fang**
   **Xiamen**
   **Fujian 361015 (CN)**

(74) Representative: **Goddar, Heinz J.**
   **Boehmert & Boehmert**
   **Anwaltspartnerschaft mbB**
   **Pettenkoferstrasse 22**
   **80336 München (DE)**

(56) References cited:
   **CN-A- 101 424 992      CN-A- 101 676 845
   CN-A- 102 629 169      CN-A- 103 105 964
   CN-U- 203 502 934      US-A1- 2004 183 958
   US-A1- 2008 062 142**

## Description

## BACKGROUND OF THE DISCLOSURE

Field of Invention

The present disclosure relates to touch sensing technology, and in particular to a method of manufacturing a touch panel.

Description of Related Art

On the current consumer electronics market, touch panels have been applied to various electronic products, such as smart phones, mobile phones, tablet computers and notebook computers. Since users can perform operations and give instructions directly through images displayed on a screen, the touch panels provide user-friendly operation interfaces between users and electronic products.

However, along with the ever-increasing requirements for lightness and thinness in structure of the touch panels and low cost in manufacturing process, there is still a need of further improvement to currently existing touch panel structures and manufacturing processes.

US 2004/0183958 A1 discloses a display device comprising a display part including a first thin plate having flexibility and a second thin plate having flexibility, the second thin plate being provided on the first thin plate; a fixing portion which fixes the first thin plate and the second thin plate together on a first direction within each main surface of the first and second thin plates; and a close contact member which is provided in a second direction perpendicular to the first direction within the main surface, and which brings the first thin plate and the second thin plate into close contact. In a specific embodiment, this document describes the manufacturing of a TFT array by forming polysilicon TFTs or amorphous silicon TFTs on a glass substrate, then removing the glass substrate, and transferring TFTs on the surface thereof to a plastic substrate. The TFTs and the array substrate are bonded together with a UV curing adhesive, thermosetting adhesive, thermoplastic or the like. The structures are made such that a color filter layer and pixel electrodes are layered, in addition to the TFT array, on the glass substrate, and the pixel electrodes and TFTs are connected by contact holes provided in the color filter layer, and only transparent electrodes are formed on the other plastic substrate.

## SUMMARY

The embodiment of the present disclosure provides a touch panel manufacturing method, so as to meet the requirements that a touch panel is lighter and thinner in structure and lower in cost in manufacturing process.

A method of manufacturing a touch panel includes: a step S1 of forming a thin film layer on a first substrate; a step S2 of forming a buffer layer on the thin film layer, and the thin film layer is located between the first substrate and the buffer layer; a step S3 of forming a sensing layer on the buffer layer, and the buffer layer is located between the thin film layer and the sensing layer; a step S4 of forming a second substrate on the sensing layer, and the sensing layer is located between the buffer layer and the second substrate; a step S5 of removing the first substrate from the thin film layer; a step S6 of adhering a cover plate onto the thin film layer by a bonding layer, and the bonding layer is located between the cover plate and the thin film layer; and a step S7 of removing the second substrate.

In the method of manufacturing the touch panel provided by the present disclosure, two substrates, namely the first substrate and the second substrate, are introduced into the touch panel manufacturing process. In some embodiments, though the two substrates do not constitute parts of the final touch panel, the two substrates play a great role in the touch panel manufacturing process. By the supporting ability of the first substrate, the sensing layer is formed on the thin film layer, and then the first substrate is removed, and subsequently by the transferring ability of the second substrate, the thin film layer and the sensing layer formed thereon are adhered to the cover plate. Therefore, the formed touch panel is lighter and thinner and lower in manufacturing cost.

Additionally, in the touch panel structure provided by the embodiment of the present disclosure, the sensing layer is located on the other side of the thin film layer adhering to the cover plate, thereby preventing the adhering flatness between the thin film layer and the cover plate from being affected during the subsequent bonding between the sensing layer and a flexible printed circuit.

Moreover, the buffer layer is formed between the thin film layer and the sensing layer. By the characteristics of the buffer layer, the characteristic differences between the thin film layer and the sensing layer, such as the difference of refractive index and the difference of coefficient of thermal expansion, between the thin film layer and the sensing layer, can be reduced. Furthermore, due to existence of the buffer layer, the erosion to the thin film layer in the process of forming the sensing layer can be reduced, and the damage to the thin film layer and the sensing layer caused by stress during the removal of the first substrate can be further reduced.

## BRIEF DESCRIPTION OF THE DRAWINGS

Figs. 1A-1H are schematic views of different steps of a touch panel manufacturing method according to some embodiments of the present disclosure;

Figs. 2A-2B are schematic views of different steps of a touch panel manufacturing method according to some embodiments of the present disclosure;

Figs. 3A-3D are schematic views of different steps of a touch panel manufacturing method according to some embodiments of the present disclosure; and

Fig. 4 is a structural schematic view of a sensing layer of a touch panel according to some embodiments of the present disclosure.

Reference numbers in the drawings:

10, 20 ~ touch panel;

30 ~ film element;

100, 300 ~ first substrate;

200 ~ protective layer;

110 ~ first adhesive layer;

120 ~ loading layer;

121 ~ thin film layer;

122 ~ buffer layer;

130 ~ sensing layer;

131- first electrode blocks;

132 ~ first wires;

133 ~ second electrode blocks;

134 ~ second wires;

135 ~ insulating blocks;

136 ~ signal lines;

140 ~ second adhesive layer;

150 ~ second substrate;

160 ~ bonding layer;

170 ~ cover plate;

180 ~ mask layer;

310 ~ third substrate;

M~ central region;

N ~ peripheral region;

V ~ regions;

CC' ~ cutting line;

A, B ~ surface.

## DETAILED DESCRIPTION

The present disclosure is described in detail in the following embodiments in connection with the accompanying drawings.

Repeated component symbols may be used in different embodiments of the disclosure, which does not represent that there is any relevance between the different embodiments or drawings. Additionally, the case that one component is formed "above" or "below" another component may include an embodiment in which the two components are in direct contact, or an embodiment in which other additional components are sandwiched between the two components. Various components can be displayed in any scale so as to make the drawings be clear and concise.

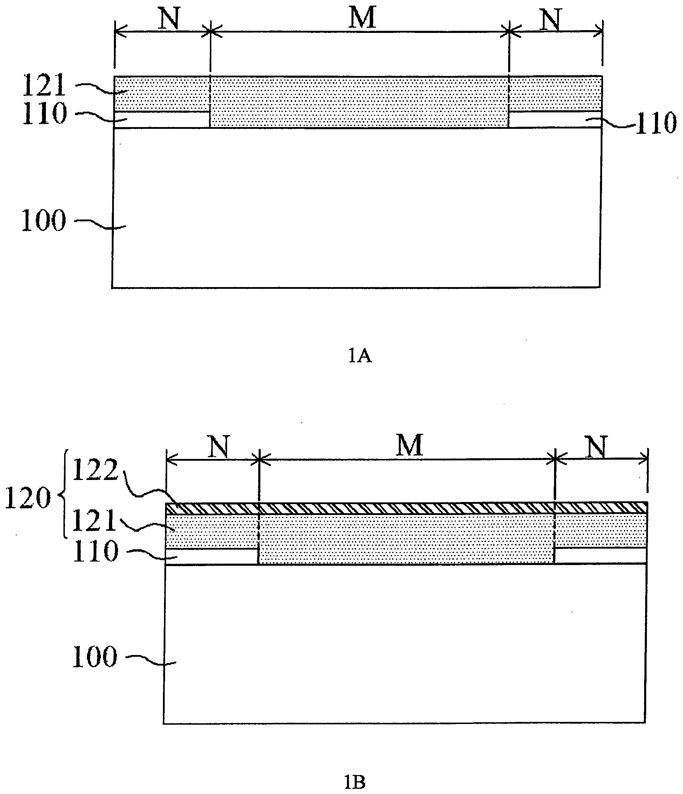

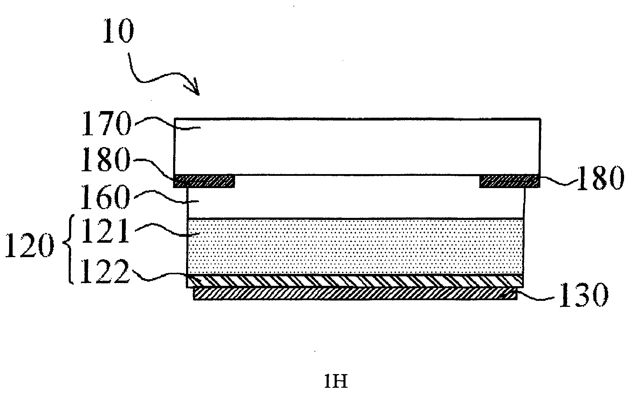

Figs. 1A-1H are schematic views of different steps of a touch panel manufacturing method according to some embodiments of the present disclosure. Herein, Fig. 1H is a structural schematic view of a touch panel formed by a manufacturing method according to some embodiments of the present disclosure.

Referring to Fig. 1A, at first, a first substrate 100 is provided, and a thin film layer 121 is formed on the first substrate 100. The first substrate 100 can serve as a mechanical support for a structure formed in a subsequent step, and the first substrate 100 can be a transparent or opaque substrate, such as a glass substrate. Since the first substrate 100 does not form a part of a finally formed touch panel product, the first substrate 100 can be made of a material relatively low in cost, as long as the first substrate 100 can provide necessary mechanical support. For example, the first substrate 100 can be made of a simple raw glass rather than chemically strengthened glass, so as to reduce the manufacturing cost of the touch panel. Additionally, after subsequently being removed from the touch panel, the first substrate 100 can be reused, so that the manufacturing cost is further reduced. It should be noted that the material of the first substrate 100 is not limited to glass, and may be made of any other appropriate material capable of providing mechanical support.

The thin film layer 121 may be of a single-layer or multi-layer structure or a stacked structure formed by a lower layer material having a separation ability and an upper layer material having no separation ability. The separation as used herein and hereinafter refers to removing the first substrate (or the second substrate) from other layers (such as the thin film layer 121) originally adhering to the first substrate (or the second substrate). Compared with conventional glass, the thin film layer 121 can be made of an organic material, such as polyimide (PI). Moreover, the thin film layer 121 can be made of polypropylene (PP), polystyrene (PS), acrylonitrile-butadiene-styrene (ABS), polyethylene terephthalate (PET), polyvinyl chloride (PVC), polycarbonate (PC), polyethylene (PE), polymethylmethacrylate (PMMA), polytetrafluoroethylene (PTFE) and cycloolefin copolymers (COP and Arton), or the combinations thereof.

The thin film layer 121 can be formed on the first substrate 100 by coating with a solution and thermal baking thereafter. For example, the thin film layer 121 made of polyimide is taken as an example for illustration. The first substrate 100 is placed on a movable platform, coated with a solution at a certain proportion by a coating cutter head or a coating machine, and then thermal-baked, so that portion of the solvent is volatilized and/or portion of components in the solution (such as polymeric monomers or precursors) are polymerized, and thus a polyimide thin film is formed. Herein, the thickness of the formed polyimide thin film can be adjusted by pressure, adjusting the solution to an appropriate viscosity, adjusting the flow speed of the solution, and controlling the moving speed of the platform. The thermal baking may include multiple times of baking at different temperatures, such as pre-baking and re-baking, and may also be a continuous baking process at a graded temperature. The aforesaid solution includes soluble polyimide (SPI) and an organic solvent, or includes a polyamide acid (PAA) and an organic solvent, wherein the PAA is a precursor of polyimide, and the organic solvent includes dimethylacetamide (DMAC), N-methyl pyrrolidone (NMP), ethylene glycol monobutyl ether (BC) and R-butyrolactone (GBL) and the like. The method of forming the thin film layer 121 is not limited thereto. For example, the thin film layer 121 may also be formed by a vapor deposition method or other appropriate methods. In other embodiments, a polyimide dry film may be directly laminated on the first substrate 100.

The thin film layer 121 formed by the polyimide can be modified by methods such as modification of composition and structure, copolymerization and blending, so as to yield a polyimide thin film with more excellent performance. For example, by changing the molecular chain length and/or a functional group of polyimide and/or by changing the surface microstructure of polyimide in a physical method, the thin film layer 121 formed by polyimide has low water absorptivity because high water absorptivity may affect the performance of the thin film layer 121 or the visual appearance of the finally formed touch panel. Generally, when the molecular chain is longer, the water absorptivity is higher. Polyimides of different molecular chain lengths show different viscosities, and the viscosity of polyimide can be changed according to specific needs. Polyimide can also have low water absorptivity by changing functional groups. For example, by changing halogen functional groups of polyimide, polyimide has fluorine-containing functional groups. Moreover, fluorine-containing polyimide can filter out light with short wavelengths. For example, the fluorine-containing polyimide can absorb ultraviolet light (the wavelength is 10-400 nm), thereby preventing the ultraviolet light from going through the thin film layer 121 and damaging the sensing layer formed in a subsequent step. In addition, the chromaticity of the touch panel can be improved, thereby preventing the touch panel from being unduly blue or unduly purple. The thin film layer 121 formed by polyimide has high transparency, high temperature resistance and low water absorptivity. Due to the high temperature resistance characteristic of the thin film layer 121, the thin film layer 121 can adapt to the temperature influenced during the forming of the sensing layer in a subsequent step; and the low water absorptivity prevents the thin film layer 121 from expanding due to water absorption during the subsequent process of forming the sensing layer, so as to prevent an electrode pattern of the sensing layer from being stereoscopic and visible, which would affect appearance of the touch panel. Furthermore, due to the low water absorptivity, the service life of the touch panel can be prolonged.

The thin film layer 121 provided by the embodiment of the present disclosure has a thinner thickness than polyethylene terephthalate (PET). The thickness of the thin film layer 121 can be about 0.1-15 microns and is preferably about 2-5 microns, and the present disclosure is not limited to this. The thickness of the thin film layer 121 is thinner than that of an ordinary glass substrate, and the thin film layer 121 within this thickness range has good mechanical properties including ductility, toughness and thermal stability. The thin film layer 121 further has good optical characteristics, such as a high transmittance. By the lighter and thinner thin film layer in the present disclosure, the thickness and weight of the touch panel can be greatly reduced, and good optical characteristics and product appearance can still be maintained.

In some embodiments, the thin film layer 121 can be adhered to the first substrate 100 through a first adhesive layer 110. Generally, the adhesive force between the first substrate 100 (such as glass) and the thin film layer 121 (such as an organic polymer) is weak, and the first substrate 100 and the thin film layer 121 cannot be adhered tightly. In order to improve the adhesive force between the first substrate 100 and the thin film layer 121, the first adhesive layer 110 is arranged between the first substrate 100 and the thin film layer 121.

The first adhesive layer 110 is an adhesion promoter comprising both pro-organic functional groups and pro-inorganic functional groups, and can be formed on the first substrate 100 by curing after solution coating. When the first substrate 100 is made of inorganic materials such as glass while the thin film layer 121 is made of organic materials such as polyimide, different functional groups contained in the first adhesive layer 110 can adapt to adhesion characteristics of two different materials, so that the thin film layer 121 is firmly fixed to the first substrate 100. For example, when the first adhesive layer 110 is cured by heating, the first adhesive layer 110 is crosslinked with the first substrate 100 and accordingly adheres to the first substrate 100 well; in the process of forming the thin film layer 121, the thin film layer 121 usually also needs to be baked by heating, so that the first adhesive layer 110 can also be crosslinked with the thin film layer 121, and thus the thin film layer 121 adheres to the first substrate 100 well.

Meanwhile, since the thin film layer 121 may be required to be removed from the first substrate 100 more easily, the first adhesive layer 110 can be arranged to be located around the first substrate 100. For example, the first adhesive layer 110 is located in a peripheral region N of the first substrate 100, so that a part of the thin film layer 121 in the peripheral region N adheres to the first substrate 100 well; and in a region (such as a central region M) of the thin film layer 121 outside the peripheral region N, the adhesiveness between the thin film layer 121 and the first substrate 100 is relatively low since there is no first adhesive layer 110. Therefore, while the first adhesive layer 110 is not yet removed, the thin film layer 121 can be tightly attached to the first substrate 100, and after the first adhesive layer 110 is removed, the first substrate 100 and the thin film layer 121 can be separated conveniently. A specific removing method is described in detail below.

In other embodiments, the first adhesive layer 110 can wholly cover the first substrate 100; that is, the first adhesive layer 110 is located between the first substrate 100 and the thin film layer 121. Under this design, the first adhesive layer 110 can be made of a material with a changeable adhesion characteristic; that is to say, in the manufacturing process, there is high adhesive force between the first adhesive layer 110 and the first substrate 100, and when the first substrate is required to be removed, the adhesiveness can be reduced by particular solution soaking or temperature treatment or the like, so as to benefit the removal of the first substrate 100 from the thin film layer 121.

Next, referring to Fig. 1B, the buffer layer 122 is formed on the thin film layer 121, and the thin film layer 121 is located between the first substrate 100 and the buffer layer 122. The buffer layer 122 can be made of transparent insulating materials. In some embodiments, the buffer layer 122 can be made of silicon oxide and can be formed by chemical vapor deposition (CVD), printing, photoetching or other appropriate methods. In other embodiments, the buffer layer 122 includes titanium dioxide $(TiO_2)$, silicon dioxide $(SiO_2)$, zirconium dioxide $(ZrO_2)$, tantalum oxide, tungsten oxide, yttrium oxide, cerium oxide, antimony oxide, niobium oxide, boron trioxide, cerium fluoride, magnesium fluoride, calcium fluoride or the combinations of the foregoing. In a further embodiment, the buffer layer 122 includes a composite material formed by organic materials and inorganic materials, wherein the inorganic materials include titanium dioxide $(TiO_2)$, silicon dioxide $(SiO_2)$, zirconium dioxide $(ZrO_2)$, tantalum oxide, tungsten oxide, yttrium oxide, cerium oxide, antimony oxide, niobium oxide, boron trioxide, aluminum oxide, zinc oxide, indium oxide, cerium fluoride, magnesium fluoride, calcium fluoride or the combinations of the foregoing. The aforesaid organic materials include high molecular polymers or resin, such as acrylic resin, polyimide (PI), polypropylene (PP), polystyrene (PS), acrylonitrile-butadiene-styrene (ABS), polyethylene terephthalate (PET), polyvinyl chloride (PVC), polycarbonate (PC), polyethylene (PE) and polymethylmethacrylate (PMMA) and the like.

Furthermore, in some embodiments of the present disclosure, the aforesaid organic materials can co-exist with the inorganic materials. For example, in a hybrid material, the organic materials and the inorganic materials can be mixed at the nanometer level to form a novel molecular composite material. The inorganic materials can be mixed or combined with the organic materials by intermolecular acting force, such as Van der Waals force, hydrogen bonds, ionic bonds or covalent bonds. In other embodiments, an organic and inorganic mixture is formed by coating organic material particles with inorganic materials or embedding inorganic material particles in an organic layer.

The composite material formed by the organic materials and the inorganic materials has characteristics of the organic materials and characteristics of the inorganic materials, and by the characteristics, the composite material can meet various requirements for high performance. For example, the buffer layer 122 including the organic materials and the inorganic materials has a good adhering ability to both organic materials and inorganic materials, so that the buffer layer 122 can be suitable for different thin film layer materials.

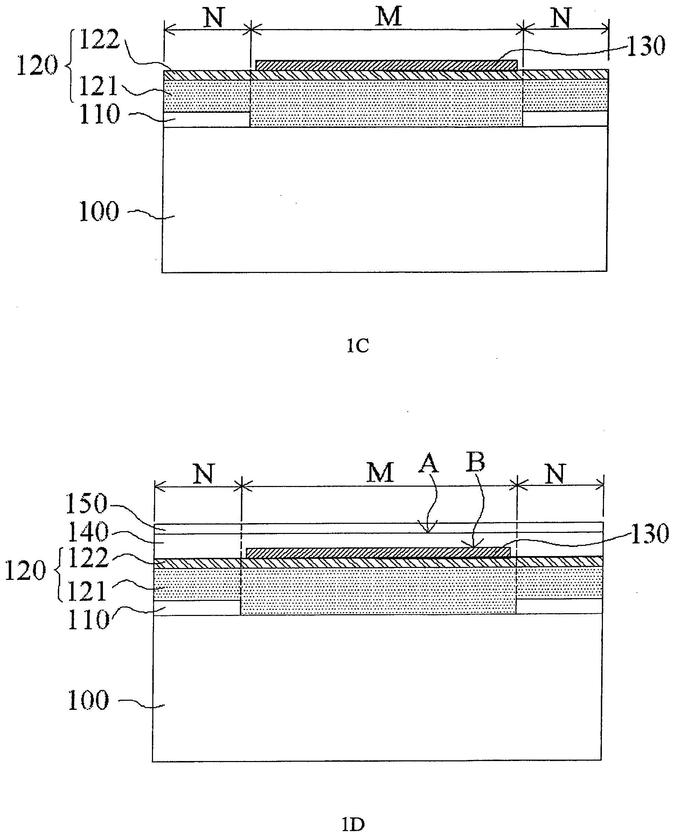

Next, referring to Figs. 1B and 1C, the sensing layer 130 is formed on the buffer layer 122 and located in the central region M of the first substrate 100. Compared with a buffer layer made of a single type of material, the buffer layer 122 made of the composite material can adapt to the requirements of the touch panel having different appearance demands by selecting materials with different refractive indexes. In detail, by adjusting the refractive index and thickness of the buffer layer 122, it is possible to make the refractive index of the buffer layer 122 match with the refractive index of an upper layer on the buffer layer 122 and the refractive index of a lower layer under the buffer layer 122. In this way, the transmittance of the touch panel can be improved, and the problem that the touch panel is poor in appearance is solved. For example, if the refractive index of the buffer layer 122 is $n_1$, the refractive index of the thin film layer 121 is $n_f$ and the refractive index of the sensing layer 130 is $n_T$, then $n_1$ should be greater than $n_f$, but smaller than $n_T$, i.e., $n_f < n_1 < n_T$, and preferably,

$$n_1 \approx \sqrt{n_f \times n_T}$$

In this way, the optical properties, such as the refractive indexes of the thin film layer 121, the buffer layer 122 and the sensing layer 130 which are sequentially arranged are in an increasing order or a decreasing order. Therefore, light can go through the three layers smoothly, and the difference of light refractive indexes of a region with electrode blocks and a region without electrode blocks in the sensing layer 130 can be reduced, the visibility of an electrode pattern is lowered, and the visual appearance of the touch panel is improved.

In addition, the buffer layer 122 is also capable of functioning as a buffer to reduce the mechanical stress generated between the thin film layer 121 and the buffer layer 122 and between the sensing layer 130 and the buffer layer 122 respectively. This is particularly important in certain situations, such as during significant temperature increase or decrease, or peeling the glass substrate 100 off. As described above, the thin film layer 121 can be made of organic materials, such as polyimide (PI). On the other hand, the sensing layer 130 is usually made of inorganic materials. In this regard, the thin film layer 121 formed by polyimide has a relatively high coefficient of thermal expansion (CTE) while the sensing layer 130 has a relatively low coefficient of thermal expansion. Besides, the thin film layer 121 formed by polyimide and the sensing layer 130 also differ greatly in mechanical properties. Therefore, high stress is generated between the thin film layer 121 and the sensing layer 130, and the stress not only induces an adverse effect (for example, the aforesaid electrode pattern is visible) on the visual appearance of the touch panel, but also may cause damage to the thin film layer 121 during the removal of the first substrate 100. The buffer layer 122 is added between the thin film layer 121 and the sensing layer 130, and through the buffering ability of the buffer layer 122, the stress possibly generated between the thin film layer 121 and the sensing layer 130 is effectively reduced. In this way, the quality of the touch panel can be improved greatly by adding the buffer layer 122 between the thin film layer 121 and the sensing layer 130.

Based on the above, the coefficient of thermal expansion of the buffer layer 122 is in a range between the coefficient of thermal expansion of the thin film layer 121 and the coefficient of thermal expansion of the sensing layer 130. For example, if the coefficient of thermal expansion of the thin film layer 121 made of polyimide is 1000 while the coefficient of thermal expansion of the sensing layer 130 is a single-digit value, the coefficient of thermal expansion of the buffer layer 122 is preferably a three-digit value, and is not unduly close to the coefficient of thermal expansion of the sensing layer 130. For example, the range of the coefficient of thermal expansion of the buffer layer 122 is greater than 100; meanwhile, the coefficient of thermal expansion of the buffer layer 122 is not unduly close to that of the thin film layer 121. For example, the coefficient of thermal expansion of the buffer layer 122 is less than 900. Therefore, the coefficient of thermal expansion of the buffer layer 122 is close to the median of the coefficient of thermal expansion of the thin film layer 121 and the coefficient of thermal expansion of the sensing layer 130. That is another reason why the buffer layer 122 is formed by the organic materials and the inorganic materials, and the coefficient of thermal expansion of the buffer layer 122 can be adjusted conveniently.

In addition, the thickness of the buffer layer 122 is usually within a range between about 10 angstroms and about 3000 angstroms. The buffer layer 122 can be formed by printing, coating or photoetching. For example, the buffer layer 122 can be formed by a convex board such as an Asahikasei photosensitive resin (APR) plate in a manner of transfer print. The buffer layer 122 formed in the manner of transfer print can reduce the stress between the sensing layer formed in a subsequent step and the thin film layer 121, thereby reducing deformation and the like of the sensing layer due to stress effect. In some embodiments, the buffer layer 122 is formed on the thin film layer 121 by solution coating, ultraviolet curing, heating and further curing.

The buffer layer 122 and the thin film layer 121 cooperatively form a loading layer 120 located on the first substrate 100. The buffer layer 122 has high hardness relative to the thin film layer 121. The loading layer 120 formed by the buffer layer 122 having high hardness and the thin film layer 121 having good ductility can simultaneously have good separation ability and good loading ability and can improve reliability of other elements formed on the loading layer 120 in subsequent steps. Compared with a buffer layer 122 made of a single material (such as silicon dioxide), the aforesaid buffer layer 122 made of the composite material benefits to adjust the stress thereof, and thus the stability of the whole touch structure during separation is improved.

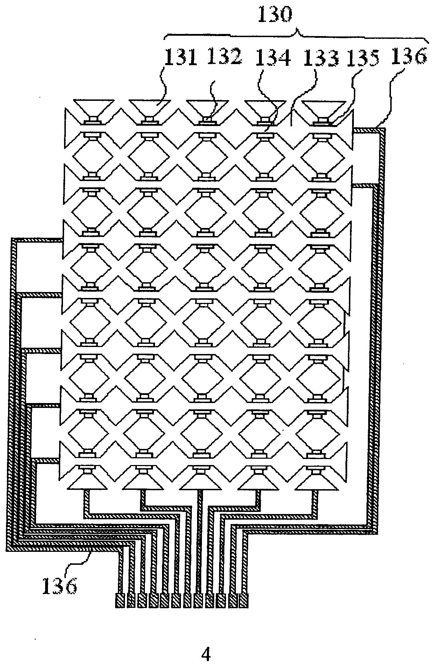

Next, referring to Figs. 1C and 4, Fig. 4 is a structural schematic view of a sensing layer of a touch panel according to some embodiments of the present disclosure. The sensing layer 130 includes multiple first electrode blocks 131 arranged along a first direction, multiple first wires 132 for connecting adjacent first electrode blocks 131 along the first direction, and multiple second electrode blocks 133 arranged along a second direction. All the second electrode blocks 133 are distributed on the two sides of the first wires 132, and insulating blocks 135 are formed on all the first wires 132 respectively. Second wires 134 for connecting adjacent second electrode blocks 133 along the second direction are formed on the insulating blocks 135. That is, the insulating blocks 135 are located between the first wires 132 and the second wires 134 so that the first wires 132 and the second wires 134 are electrically insulated from each other. Herein, the first direction is different from the second direction, and preferably, the first direction and the second direction are perpendicular to each other. What needs describing is that the structure of the sensing layer 130 is not limited to the structure as shown in Fig. 4. For example, the sensing layer 130 can be of a comb-shaped, cross-shaped or wavy single-layer electrode structure; or in other embodiments, the sensing layer 130 can be a multilayer structure. For example, an electrode along the first direction, an electrode along the second direction and an insulating layer located between the first electrode and the second electrode are located on three independent layers respectively.

The specific steps of forming the sensing layer 130 can include the steps of first forming the first wires 132 on the buffer layer 122, then forming the insulating blocks 135 on all the first wires 132, and finally forming the first electrode blocks 131, the second electrode blocks 133 and the second wires 134. Or in another embodiment, the first electrode blocks 131, the second electrode blocks 133 and the first wires 132 can be formed first, then the insulating blocks 135 are formed on all the first wires 132, and finally the second wires 134 are formed on the insulating blocks 135.

In addition, the steps of forming the sensing layer 130 further include the step that multiple signal lines 136 are formed. The first electrode blocks 131 located in the same axial direction are electrically connected with each other through the first wires 132 to form a sensing electrode array and then are electrically connected with the corresponding signal line 136. The second electrode blocks 133 located in the same axial direction are electrically connected with each other through the second wires 134 to form a sensing electrode array and then are electrically connected with the corresponding signal line 136. Sensing signals generated by the first electrode blocks 131 and the second electrode blocks 133 are transmitted to a controller (not shown in the figure) through the signal lines 136, and the controller can perform calculation according to the sensing signals to obtain the touch position. An arrangement manner and number of the signal lines 136 can be adjusted according to structures of different sensing layers 130, and are not limited to the form in Fig. 4. In detail, there can be multiple areas for collecting the signal lines 136, and one sensing electrode array can also be connected with two of the signal lines 136 arranged on opposite sides of the sensing electrode array.

The first electrode blocks 131 and the second electrode blocks 133 are made of transparent conductive materials, which include indium tin oxide (ITO), aluminum zinc oxide, zinc oxide, tin antimony oxide, tin dioxide, indium oxide or the combinations thereof. The first electrode blocks 131 and the second electrode blocks 133 can also be made of conductive materials such as nano-silver, carbon nanotubes or metal meshes. The first wires 132, the second wires 134 and the signal lines 136 can be made of transparent conductive materials the same as the aforesaid electrode blocks, and can also be made of non-transparent conductive materials, such as metals or alloys which include gold, silver, copper, molybdenum, aluminum or combinations thereof. The first electrode blocks 131, the second electrode blocks 133, the first wires 132 and the second wires 134 can be formed by steps of sputtering or photoetching, and can also be formed by screen printing and spray coating or the like.

For the touch panel in the present disclosure, in some embodiments, the first electrode blocks 131, the second electrode blocks 133, the first wires 132 and the second wires 134 are made of indium tin oxide formed by sputtering on the conditions of low temperature, and the low temperature is in a range from about 20 degrees centigrade to 80 degrees centigrade. Compared with high-temperature sputtering, the indium tin oxide formed by low-temperature sputtering has lower integral stress and accordingly benefits the stability of the whole touch structure formed on the loading layer 120 during the subsequent removal of the first substrate 100. In detail, at first, the first wires 132 are formed by sputtering and photoetching on the conditions of low temperature. At this stage, the first wires 132 are made of non-crystalline indium tin oxide; then the first wires 132 are baked, so that the non-crystalline indium tin oxide is converted to crystalline indium tin oxide; next, the insulating blocks 135 are formed on the first wires 132; and then the first electrode blocks 131, the second electrode blocks 133 and the second wires 134 are formed by sputtering and photoetching on the conditions of low temperature, and at this stage, the first electrode blocks 131, the second electrode blocks 133 and the second wires 134 are all made of the non-crystalline indium tin oxide; and finally, the first electrode blocks 131, the second electrode blocks 133 and the second wires 134 are baked, so that the non-crystalline indium tin oxide is converted to the crystalline indium tin oxide. The aforesaid baking temperature is greater than or equal to 180 degrees centigrade and less than or equal to 350 degrees centigrade, and is preferably greater than or equal to 220 degrees centigrade and less than or equal to 240 degrees centigrade.

By baking the first wires 132, the problem that etchant used during the forming of the first electrode blocks 131, the second electrode blocks 133 and the second wires 134 erodes the formed first wires 132 is prevented. Besides, the transmittance of the first wires 132 can be improved, the impedance of the first wires 132 is reduced, and the conductivity of the first wires 132 is improved. Similarly, by baking the first electrode blocks 131, the second electrode blocks 133 and the second wires 134, the transmittance of the first electrode blocks 131, the second electrode blocks 133 and the second wires 134 can also be improved, the impedance of the first wires 132 is reduced, and the conductivity of the first wires 132 is improved.

In other embodiments, the first electrode blocks 131, the second electrode blocks 133 and the second wires 134 can be formed by sputtering and photoetching on the conditions of low temperature, and at this stage, the first electrode blocks 131, the second electrode blocks 133 and the first wires 132 are made of non-crystalline indium tin oxide; then, the first electrode blocks 131, the second electrode blocks 133 and the first wires 132 are baked, so that the non-crystalline indium tin oxide is converted to crystalline indium tin oxide; next, the insulating blocks 135 are formed on the first wires 132; the second wires 134 are formed, and at this stage, the second wires 134 are made bf non-crystalline indium tin oxide; and finally the second wires 134 are baked, so that the non-crystalline indium tin oxide is converted to the crystalline indium tin oxide. In this embodiment, the indium tin oxide is taken only as an example for description, and the present disclosure is not limited to this.

Next, referring to Fig. 1D, the second substrate 150 is formed on the sensing layer 130 and is able to cover the buffer layer 122 partially or even entirely. The second substrate 150 is adhered to the sensing layer 130 and the buffer layer 122 by a second adhesive layer 140. Materials of the second substrate 150 include, for example, polymers of polyethylene terephthalate (PET) or any appropriate material, such as glass, cycloolefin copolymers (COP and Arton) and propene polymer (PP), that is able to support a film element, so that the film element can be transferred to a cover plate according to an embodiment of the present disclosure. The second adhesive layer 140 can be a removable adhesive and may include water insoluble glue or any other appropriate material that can adhere two layers temporarily and can be dissolved in subsequent steps or removed by other processes. In some embodiments, the second substrate 150 and the second adhesive layer 140 are laminated and can be, for example, a single-sided adhesive tape. The second substrate 150 is, for example, a flexible film, and the second adhesive layer 140 is an adhesive layer. As shown in Fig. 1D, the second adhesive layer 140 has a surface A and a surface B opposite to each other, and the surface proximal to the second substrate 150 is the surface A. The viscosity of the surface B of the second adhesive layer 140 can be reduced or even eliminated by light treatment such as ultraviolet irradiation, heat treatment or cold treatment or the combinations of the foregoing. Meanwhile, the surface A of the second adhesive layer 140 still has good viscosity with the second substrate 150, and thus the second adhesive layer 140 can be removed during the subsequent step of removing the second substrate 150.

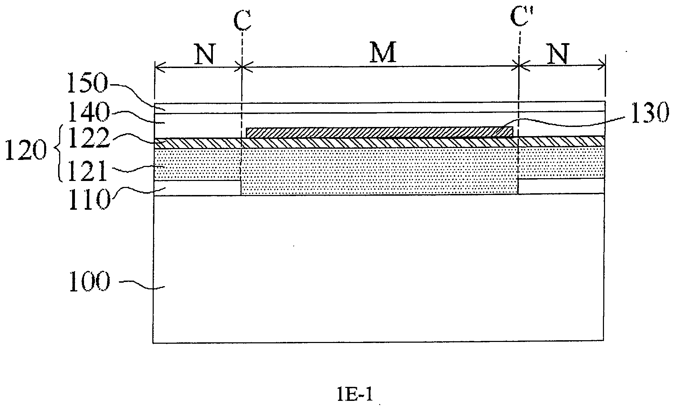

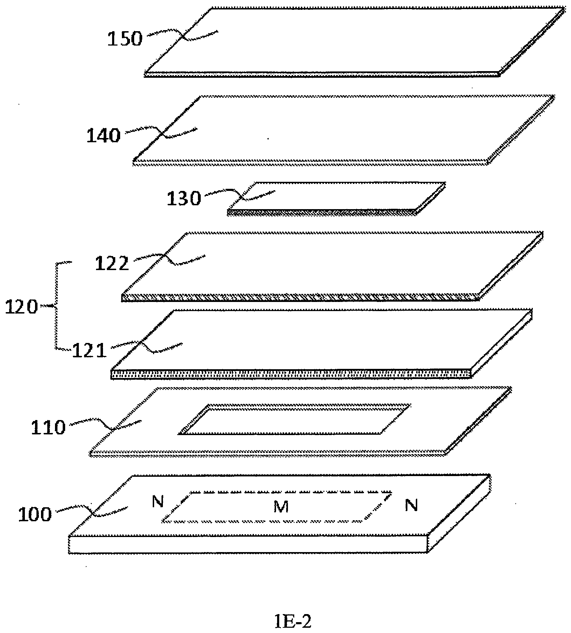

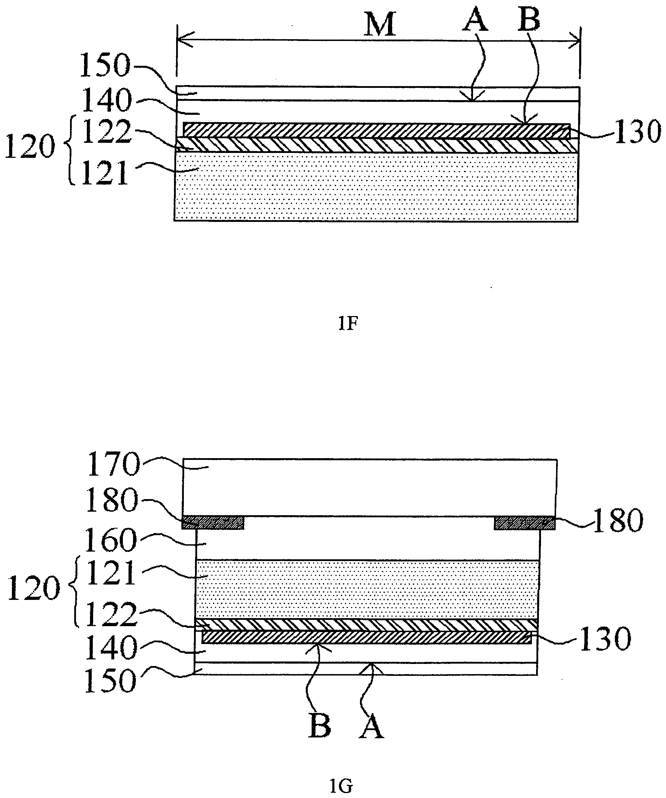

Next, referring to Figs. 1E-1, 1E-2 and 1F, herein, Fig. 1E-2 is an exploded view of Fig. 1E-1, showing the first substrate 100 removed from the thin film layer 121. As shown in Figs. 1E-1 and 1E-2, cutting can be performed along the edge of the peripheral region N proximal to the central region M, i.e., along a cutting line CC' as shown in Fig. 1E-1, so that the first adhesive layer 110, the thin film layer 121, the buffer layer 122, the second adhesive layer 140 and the second substrate 150 are cut off, and then the first substrate 100 is removed from the thin film layer 121. Since the first adhesive layer 110 playing a main adhesion role is cut off, no adhesive layer is between the first substrate 100 and the thin film layer 121, and the adhesive force between the first substrate 100 and the thin film layer 121 is significantly reduced. The first substrate 100 is then removed, and the influence of stress on the thin film layer 121 and other structures formed on the thin film layer 121 can be reduced in the process of removing the first substrate 100. In addition, when the first adhesive layer 110 is removed, cutting parameters can be controlled, so that the first substrate 100 is not cut. As such, the first substrate 100 can be reused, thereby reducing the cost.

In other embodiments, the cutting can be performed along the peripheral region N proximal to the edge of the central region M and can also be performed along a cutting line CC' as shown in Fig. 1E-1. What is different from the foregoing is that not only the first adhesive layer 110, the thin film layer 121, the buffer layer 122, the second adhesive layer 140 and the second substrate 150 which are located in the peripheral region N are removed, but also a part of the first substrate 100 located in the peripheral region N is removed, and then the cut first substrate 100 is removed. Or in a further embodiment, between the step of forming the sensing layer 130 and the step of forming the second substrate 150, the cutting can be performed along the peripheral region N proximal to the edge of the central region M, so that the first adhesive layer 110, the thin film layer 121 and the buffer layer 122 which are located in the peripheral region N are removed; meanwhile, the first substrate 100 remains and is removed after the second substrate 150 is formed.

It needs to be noted that during the removing of the first substrate 100, assistance or other methods can be taken to facilitate separation. For example, the first substrate 100 can be removed from the thin film layer 121 by solution soaking, heat treatment, cold treatment, external force stripping or combinations of the foregoing. A solution used can be water, alcohol, propylene glycol methyl ether acetate (PGMEA) solution and N-methyl pyrrolidone (NMP) solution of polyvinylidene fluoride (PVDF) or the like. The heat treatment and cold treatment refer to heating or cooling of the first substrate 100, and stress is generated by the difference of coefficients of thermal expansion of the loading layer 120 and the first substrate 100, so as to facilitate separation.

Next, referring to Fig. 1G, a cover plate 170 is adhered to the thin film layer 121. The cover plate 170 and the thin film layer 121 can be adhered by a bonding layer 160 by lamination or other means. The bonding layer 160 is located between the thin film layer 121 and the cover plate 170. As shown in Fig. 1G, the cover plate 170, the bonding layer 160, the thin film layer 121, the buffer layer 122, the sensing layer 130, the second adhesive layer 140 and the second substrate 150 are stacked in that order from top to bottom.

The cover plate 170 is able to protect the structures below it and can be made of transparent materials such as glass, polyimide (PI), polypropylene (PP), polystyrene (PS), acrylonitrile-butadiene-styrene (ABS), polyethylene terephthalate (PET), polyvinyl chloride (PVC), polycarbonate (PC), polyethylene (PE), polymethylmethacrylate (PMMA), polytetrafluoroethylene (PTFE) or the like. The cover plate 170 can include a hard material or a flexible material. In order to increase the strength of the cover plate 170, the six surfaces of the cover plate 170 may all be chemically strengthened, or two opposite surfaces of the cover plate 170 may be chemically strengthened and four lateral surfaces may be physically strengthened. The cover plate 170 can be formed by cutting a glass board into small pieces first, which matches the size of one touch panel module, and then chemically strengthening the above pieces. The cover plate 170 can include two planar surfaces (for example, the upper surface and the lower surface are planar surfaces), two curved surfaces (for example, the upper surface and the lower surface are curved surfaces) or one planar surface and one curved surface (for example, one of the upper surface and the lower surface is a planar surface and another is a curved surface). For example, the cover plate 170 can be formed in a 2.5D shape or a 3D shape. The upper surface of the cover plate 170, which is opposite to the thin film layer 121, can serve as a contact surface for being in touch with an object. The bonding layer 160 can be made of solid or liquid optical adhesive or other appropriate transparent bonding materials.

The loading layer 120 and the sensing layer 130 of the present disclosure can be referred to as a film element. Compared with an ordinary touch module which includes a glass substrate and a thin film layer, or two thin film layers, or two glass substrates serving as loading plates and then combined with corresponding sensing layers, the film element of the present disclosure is thinner and more flexible and can serve as a touch element to adhere to hard substrates with different curvature radius or adhere to a flexible substrate. Thus, the film element can adapt to the design requirements of different touch panels more flexibly. In addition, by the transferring ability of the second substrate 150, the thin film layer 121 together with the buffer layer 122 and the sensing layer 130 are adhered to the cover plate 170. The second substrate 150 is preferably made of a flexible material while the cover plate 170 is made of a relatively hard material, such as toughened glass, so that the flexible material can be adhered to the hard material more easily, and the bonding layer 160 can be prevented from generating bubbles, and the thickness of the bonding layer 160 can be reduced.

A mask layer 180 can be formed on the cover plate 170, and the mask layer 180 is located on at least one side of the cover plate 170 and used for shielding signal lines (such as signal lines 136 in Fig. 4). In this way, the signal lines will not be easily seen by users from one side of the upper surface of the cover plate 170. In at least one embodiment, the mask layer 180 is located on the lower surface of the cover plate 170. That is, the mask layer 180 is located on one side of the cover plate 170 proximal to the thin film layer 121. In other embodiments, the mask layer 180 can be located on the upper surface of the cover plate 170. That is, the mask layer 180 is located on the other side of the cover plate 170 opposite to the thin film layer 121. In other embodiments, the mask layer 180 can further be a decorative film which includes a transparent film, and the mask layer is arranged on a peripheral region of the transparent film. The deco-film can be directly arranged on the upper surface of the cover plate, and can also be adopted to replace the cover plate 170 and the mask layer 180. The mask layer 180 can be made of colored ink, colored photoresist or the combination of the colored ink and the colored photoresist. The mask layer 180 can be a single layer structure or a composite laminated structure, wherein the single layer structure is, for example, a black ink layer; and the composite laminated structure is, for example, a stacked structure of an ink layer and a photoresist layer, a stacked structure of a white ink layer and a black ink layer, or a stacked structure of a white ink layer, a black ink layer and a photoresist layer or the like.

Finally, referring to Figs. 1G and 1H, the second substrate 150 and the second adhesive layer 140 are removed from the sensing layer 130. Specifically, the second adhesive layer 140 can undergo pretreatment in advance, such as light treatment, heat treatment or cold treatment or combinations thereof. For example, according to the differences of materials of the second adhesive layer 140, the adhesiveness between the second adhesive layer 140 and the sensing layer 130 can be reduced by ultraviolet irradiation, heating or cooling, and then the second adhesive layer 140 and the second substrate 150 are removed from the sensing layer 130. For example, as described above, the stacked structure of the second adhesive layer 140 and the second substrate 150 can be the single-sided adhesive, and by ultraviolet irradiation, the adhesiveness between the surface B of the second adhesive layer 140 and the sensing layer 130 is reduced or even eliminated; meanwhile, the adhesiveness between the surface A of the second adhesive layer 140 and the second substrate 150 remains, and thus the second substrate 150 and the second adhesive layer 140 can be removed simultaneously and conveniently. Of course, different removal methods can be selected according to the materials of the second adhesive layer 140, and the present disclosure is not limited thereto.

The touch panel 10 as shown in Fig. 1H is finally formed through the aforesaid steps, and the top of the figure is a touch and observation surface for a user. The touch panel 10 includes the cover plate 170, the bonding layer 160, the thin film layer 121, the buffer layer 122 and the sensing layer 130 which are stacked from top to bottom; that is to say, the bonding layer 160 is located between the cover plate 170 and the thin film layer 121; the thin film layer 121 is located between the bonding layer 160 and the buffer layer 122; and the buffer layer 122 is located between the thin film layer 121 and the sensing layer 130.

Further referring to Fig. 1H, the touch panel 10 further includes the mask layer 180, and the mask layer 180 is located on at least one side of the cover plate 170. The detailed structure and materials of each component and a manufacturing method thereof have been described above, and accordingly are no longer repeated herein. The touch panel can be applied to touch display devices such as a computer system, a mobile phone, a digital media player, a tablet computer, an ultrabook, a wearable touch device and a vehicle-mounted touch system.

After the steps shown in Fig. 1A-1H are finished, a flexible printed circuit with a controller can be further adhered to the signal lines 136 by the anisotropic conductive adhesive. Compared with direct adhesion of the flexible printed circuit after the step of Fig. 1C, in the present disclosure, the adhesion of the flexible printed circuit is performed after the step of Fig. 1H is finished, so as to prevent the problem of drop proneness of the flexible printed circuit that possibly occurs in the manufacturing process of removing the first substrate 100 or the second substrate 150, thereby improving the stability of the whole touch panel.

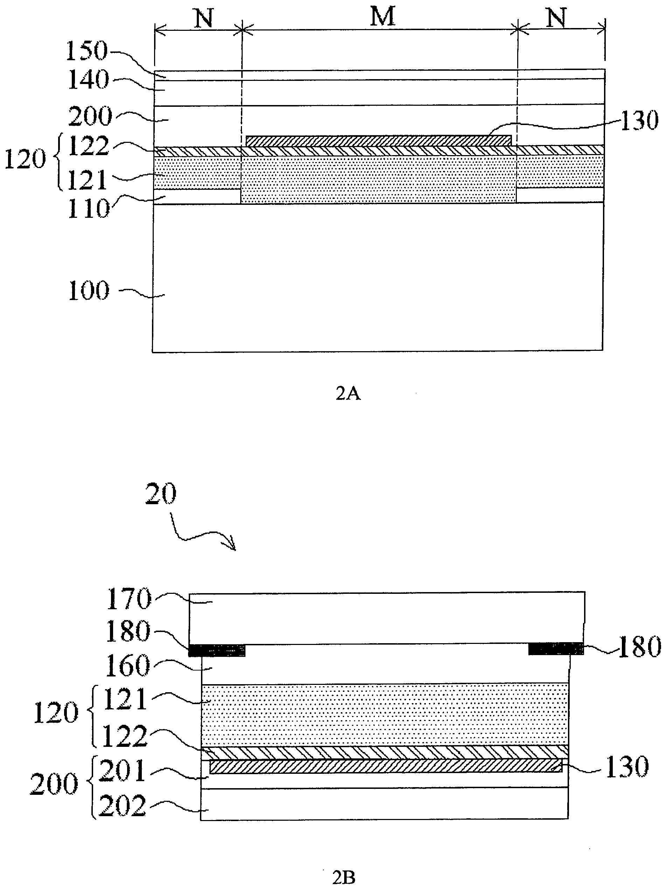

Figs. 2A-2B are schematic views of different steps of a touch panel manufacturing method according to another embodiment of the present disclosure. Fig. 2B further illustrates a structural schematic view of a touch panel according to an embodiment of the present disclosure. Fig. 2A illustrates the step following Fig. 1C. The steps prior to the step as shown in Fig. 2A are the same as those of Figs 1A-1C, and for simplicity, the steps are no longer repeated. As shown in Fig. 2A, after the forming of the sensing layer 130, the method further includes the step of forming a protective layer 200 above the sensing layer 130, and the sensing layer 130 is located between the protective layer 200 and the buffer layer 122. The protective layer 200 can protect the sensing layer 130, and the influence on the sensing layer 130 in the process of removing the second adhesive layer 140 and the second substrate 150 can be reduced. Besides, after the removal of the second adhesive layer 140 and the second substrate 150, the erosion of the sensing layer 130 caused by air, water vapor or other substances in the environment is reduced. Furthermore, the protective layer 200 needs to expose the joint of the signal lines connected with the flexible printed circuit, so as to benefit the connection of the signal line and the flexible printed circuit.

Referring to Figs. 1D-1H, the steps following the step as shown in Fig. 2A are substantially similar to the steps of Figs. 1D-1H. The difference is that the second substrate 150 and the second adhesive layer 140 are formed above the protective layer 200. That is, the second adhesive layer 140 is located between the protective layer 200 and the second substrate 150. A touch panel 20 formed by removing the first substrate 100 and the first adhesive layer 110, adhering the first substrate 100 and the first adhesive layer 110 to the cover plate 170 and then removing the second substrate 150 and the second adhesive layer 140 further includes the protective layer 200. As shown in Fig. 2B, the touch panel 20 includes the cover plate 170, the bonding layer 160, the thin film layer 121, the buffer layer 122, the sensing layer 130 and the protective layer 200 which are stacked from top to bottom. Except for the protective layer 200, structures and materials of other components and manufacturing methods thereof are described as the above and accordingly are no longer repeated.

In addition, referring to Fig. 2B, the protective layer 200 can be a single-layer structure or a multi-layer structure. For example, when of the protective layer 200 is the multi-layer structure, the protective layer 200 may include a first protective layer 201 and a second protective layer 202, wherein the first protective layer 201 is located between the sensing layer 130 and the second protective layer 202, and a display device can be adhered to one side of the second protective layer 202 distal to the first protective layer 201, so as to form a touch display device cooperatively. The first protective layer 201 and the second protective layer 202 can be made of different materials to achieve different effects.

The first protective layer 201 can be selected from at least one of organic materials, inorganic materials, composite materials or high polymer materials. In one embodiment, the first protective layer 201 can be made of the same composite material as the aforesaid buffer layer 122. For example, the composite material includes titanium dioxide ($TiO_2$), silicon dioxide ($SiO_2$), zirconium dioxide ($ZrO_2$) or the combinations thereof, or a compound formed by titanium dioxide ($TiO_2$), silicon dioxide ($SiO_2$) and organic materials, or a compound formed by zirconium dioxide ($ZrO_2$), silicon dioxide ($SiO_2$) and organic materials. By adjusting the refractive index and thickness of the first protective layer 201, and by the buffer layer 122, the problem that touch panel is poor in appearance due to the light reflection differences between a region of the sensing layer 130 with an electrode block and a region of the sensing layer 130 without an electrode block is solved. For example, if the refractive index of the first protective layer 201 is $n_2$, the refractive index of the second protective layer 202 is $n_3$ and the refractive index of the sensing layer is $n_T$, $n_3 < n_2 < n_T$,

and preferably, $n_2 \approx \sqrt{n_3 \times n_T}$. In some embodiments, the thickness of the first protective layer 201 can be about 0.01 micron to 0.3 micron.

The aforesaid first protective layer 201 mainly plays a role of refractive index matching, the second protective layer 202 mainly protects the sensing layer 130 and reduces erosion to the sensing layer 130 caused by air, water vapor or other substances in the environment. Materials of the second protective layer 202 can include appropriate transparent insulating materials such as thermosetting resin, silicon dioxide and photoresist.

The first protective layer 201 and the second protective layer 202 can be formed by a convex board such as an Asahikasei photosensitive resin (APR) plate in a manner of transfer print. The first protective layer 201 and the second protective layer 202 which are formed by the transfer print can reduce the stress effect between the sensing layer 130 and the other layers and can improve stability of the sensing layer 130. Meanwhile, the second substrate and the second adhesive layer can be removed conveniently in subsequent steps, and the stress effect is reduced. In another embodiment, the first protective layer 201 and the second protective layer 202 can be formed respectively by solution coating, ultraviolet curing and heat curing and the like. In other embodiments of the present disclosure, the protective layer 200 can also be formed by processes such as sputtering, chemical vapor deposition (CVD), inkjet printing, slit coating, spin coating, spray coating or roller coating according to requirements.

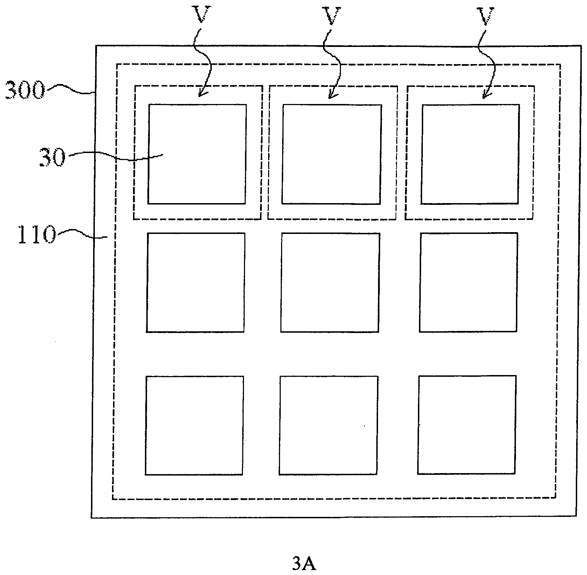

The aforesaid embodiments are described by taking independent forming of single touch panels as an example. To improve production efficiency and reduce cost, multiple film elements (each including a thin film layer, a buffer layer, a sensing layer, a protective layer, a second adhesive layer and a second substrate) can be formed on a large first substrate continuously. In a step prior to adhering the film elements to the cover plate, the multiple film elements are separated respectively, so that multiple touch panels can be formed in one process, the production efficiency is improved, and the cost is reduced. Specific manufacturing processes can be referred to corresponding embodiments of Figs. 3A-3D.

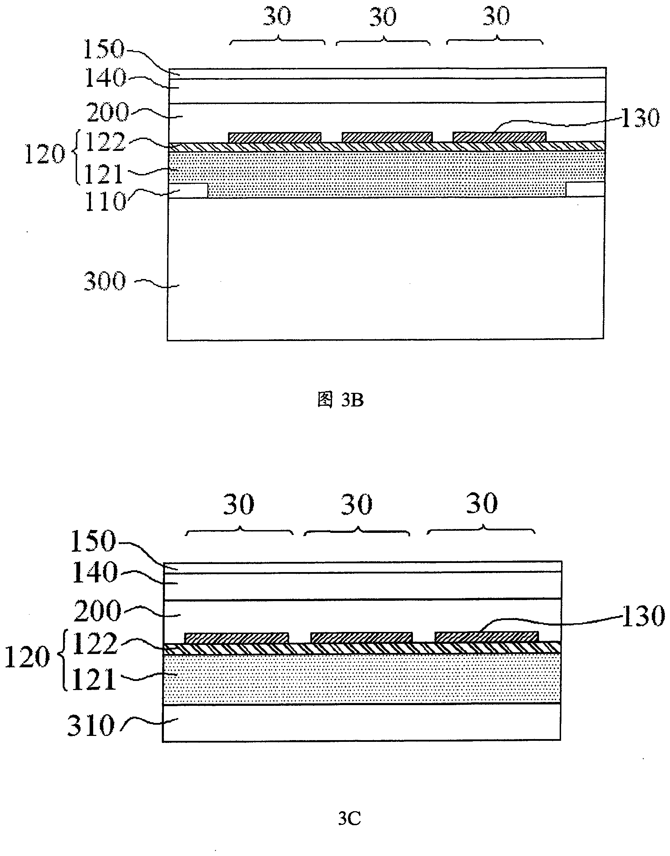

Figs. 3A-3D are schematic views of different steps of a touch panel manufacturing method according to a further embodiment of the present disclosure. Referring to Figs. 3A and 3B, herein, the Fig. 3B is a schematic cross-sectional view of Fig. 3A. Multiple regions V at intervals are predetermined or divided on a large first substrate 300, and the sizes of the regions V can be determined according to the size of the touch panel. Next, the first adhesive layer 110, the thin film layer 121 and the buffer layer 122 are sequentially formed on the first substrate 300, and multiple sensing layers 130 which are arranged at intervals with each other are simultaneously formed on the buffer layer 122 and correspond to the regions V; the protective layers 200 are formed on the sensing layers 130, and the second substrate 150 is formed on the protective layers 200 by utilizing the adhesion of the second adhesive layer 140. The multiple sensing layers 130 are arranged at intervals, and other structures such as the first substrate 300, the thin film layer 121, the buffer layer 122, the protective layers 200, the second adhesive layer 140 and the second substrate 150 are respectively integral structures. In addition, the methods of forming the first adhesive layer 110, the thin film layer 121, the buffer layer 122, the second adhesive layer 140 and the second substrate 150 can be understood from the corresponding embodiments of the aforesaid Figs. 1A-1H, and the method of forming the protective layers 200 can be understood from the corresponding embodiments of the aforesaid Figs. 2A and 2B.

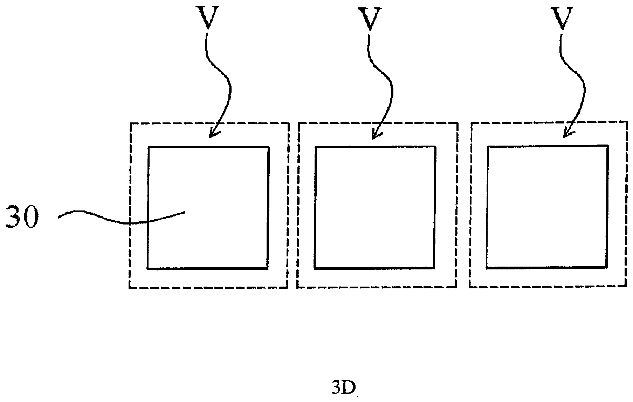

Next, referring to Figs. 3C and 3D, the first substrate 300 is removed, a film element 30 is adhered to a third substrate 310 by one side of the thin film layer 121. The thin film layer 121 is located between the buffer layer 122 and the third substrate 310. Herein, a method of removing the first substrate 300 is the same as a method in the aforesaid embodiment. The structure of the third substrate 310 can be similar to the structure of the aforesaid second substrate in combination with the second adhesive layer, and the structure of the third substrate 310 includes a flexible thin film layer and an adhesive layer, such as single-sided adhesive, wherein the flexible thin film layer and the adhesive layer are adhered to each other, and thus the surface with adhesiveness is adhered to the thin film layer 121 of the film element 30. The third substrate 310 can support and protect the film elements 30, and the damage to the film elements 30 in the subsequent separation process is avoided.

Then, the film elements 30 corresponding to the regions V are separated, and the film elements which are originally integrally connected are separated as multiple independent small film elements 30. The film elements 30 can be separated by cutting with knives or laser cutting. As shown in Fig. 3D, the separated small film elements with three pieces in one group are taken as an example in Fig. 3D, and it can be understood that the film elements can also be separated as smaller or larger film elements.

Then, the third substrate 310 is removed. Referring to Fig. 2B, the small film elements are respectively adhered to the cover plate 170, and finally the second substrate 150 and the second adhesive layer 140 are removed, so as to respectively form multiple touch panels. The finally formed touch panel structures are shown in Fig. 2B. The cover plate 170 of the embodiment can be formed by cutting a large glass substrate into the dimensions conforming to a touch module and then performing chemical enhancement. Compared with a conventional method of performing chemical enhancement on a large glass cover plate, depositing multiple sensing layers and then cutting the large glass cover plate and the sensing layers to obtain small touch panels, the cover plate 170 of this embodiment is cut in advance and then strengthened and finally adhered to the film element without the need of further cutting. Therefore, the cover plate 170 has good edge strength. A process of forming the sensing layers does not affect the strength of the cover plate, and the strength of the whole finally formed touch panels can be improved.

In the process of adopting the large first substrate 300 to form multiple touch panels as shown in Figs. 3A-3D, the first adhesive layer for adhering the thin film layers to the first substrate 300 can be arranged in a peripheral region of the large substrate 300, for example, around the large substrate 300. In another embodiment, the first adhesive layer can be further arranged around each region V, so as to further enhance the adhesiveness between the thin film layers and the first substrate 300. Therefore, during the removal of the first substrate 300, the first adhesive layer located around the first substrate 300 and adhesive layers located around each region V are removed together; or the first adhesive layer is only arranged around each region V and is not arranged around the first substrate 300, and the present disclosure is not limited thereto.

According to the touch panel provided by the present disclosure and the manufacturing method thereof, the sensing layer is formed on the thin film layer by the supporting ability of the first substrate, and the thin film layer and the sensing layer formed on the thin film layer are adhered to the cover plate by the transfer ability of the second substrate. Therefore, the formed touch panel is lighter and thinner and low in manufacturing cost. In addition, the sensing layer is located on the other side of the thin film layer adhering to the cover plate, so that the problem that the adhering flatness between the thin film layer and the cover plate is affected during the connection of the sensing layer and the flexible printed circuit is solved. In addition, the buffer layer is formed between the thin film layer and the sensing layer, so that the erosion of the thin film layer in the process of forming the sensing layer can be reduced, and the damage to the thin film layer and the sensing layer caused by stress during the removal of the first substrate can be further reduced.

**Claims**

1. A method of manufacturing a touch panel (10), comprising:

   S1: forming a thin film (121) layer on a first substrate (100);
   S2: forming a buffer layer (122) on the thin film layer (121), wherein the thin film (121) layer is located between the first substrate (100) and the buffer layer (122);
   S3: forming a sensing layer (130) on the buffer layer (122), wherein the buffer layer (122) is located between the thin film layer (121) and the sensing layer (130);
   S4: forming a second substrate (150) on the sensing layer (130), wherein the sensing layer (130) is located between the buffer layer (122) and the second substrate (150);
   S5: removing the first substrate (100);
   S6: adhering a cover plate (170) onto the thin film layer (121) by a bonding layer (160), wherein the bonding layer (160) is located between the cover plate (170) and the thin film layer (121); and
   S7: removing the second substrate (150).

2. The method of manufacturing the touch panel (10) of claim 1, wherein in the step S1, the thin film layer (121) is adhered to the first substrate (100) by a first adhesive layer (110), or wherein in the step S2, the buffer layer (122) is formed on the thin film layer (121) by transfer printing or by curing after solution coating.

3. The method of manufacturing the touch panel (10) of claim 1, wherein between the step S3 and the step S4, the method further comprises:
   forming a protective layer (200) on the sensing layer (130), and the sensing layer (130) is located between the buffer layer (122) and the protective layer (200).

4. The method of manufacturing the touch panel (10) of claim 3, wherein the step of forming the protective layer (200) comprises:
   forming a first protective layer (201) on the sensing layer (130), and the sensing layer (130) is located between the buffer layer (122) and the first protective layer (201); and forming a second protective layer (202) on the first protective layer (201), and the first protective layer (201) is located between the sensing layer (130) and the second protective layer (202), wherein the protective layer (200) is preferably formed by transfer printing or by curing after solution coating.

5. The method of manufacturing the touch panel (10) of claim 1, wherein in the step S4, the second substrate (150) is adhered to the sensing layer (130) by a second adhesive layer (140), or wherein the second substrate (150) is a flexible substrate, or wherein in the step S5, the first substrate (100) is removed by solution soaking, heat treatment, cold treatment, external-force stripping, or combinations thereof.

6. The method of manufacturing the touch panel (10) of claim 2, wherein the first substrate (100) defines a central region and a peripheral region surrounding the central region (M), wherein the first adhesive layer (110) is located in the peripheral region (N) of the first substrate (100), and the sensing layer (130) is located in the central region (M) of the first substrate (100), wherein the step S5 preferably comprises:
   cutting along an edge of the peripheral region (N) proximal to the central region (M) to cut off the first adhesive layer (110) located in the peripheral region (N), and then removing the first substrate (100), or wherein the step preferably S5 comprises:
   cutting along an edge of the peripheral region (N) proximal to the central region (M) to cut off the first adhesive layer (110) located in the peripheral region (N) and a part of the first substrate (100) located in the peripheral region (N), and then removing the first substrate (100).

7. The method of manufacturing the touch panel of claim 5, wherein the step S7 comprises:

performing light treatment, heat treatment, cold treatment or combinations thereof to the second adhesive layer (140), and then removing the second adhesive layer (140) and the second substrate (150).

8. The method of manufacturing the touch panel (10) of claim 1, wherein the step of forming the sensing layer (130) comprises:

forming a plurality of first wires (132) arranged at intervals along a first direction;
forming a plurality of first electrode blocks (131) arranged along the first direction, a plurality of second electrode blocks (133) arranged along a second direction and a plurality of second wires (134), wherein the first electrode blocks (131) adjacent to each other are electrically connected by the first wires (132), wherein the second electrode blocks (133) are distributed on two sides of the first wires (132), and wherein the second electrode blocks (133) adjacent to each other are electrically connected by the second wires (134); and
forming a plurality of insulating blocks (135) between the first wires (132) and the second wires (134) to electrically insulate the first wires (132) and the second wires (134).

9. The method of manufacturing the touch panel (10) of claim 8, wherein the first electrode blocks (131), the second electrode blocks (133), the second wires (134) and the first wires (132) are formed respectively at temperature in a range from 20 degrees centigrade to 80 degrees centigrade.

10. The method of manufacturing the touch panel (10) of claim 8, wherein after the step of forming the first wires (132), the method further comprises a step of baking.

11. The method of manufacturing the touch panel (10) of claim 8, wherein after the step of forming the first electrode blocks (131), the second electrode blocks (133) and the second wires (134), the method further comprises a step of baking.

12. The method of manufacturing the touch panel (10) of claim 10, wherein the baking temperature is greater than or equal to 180 degrees centigrade and less than or equal to 350 degrees centigrade, preferably greater than or equal to 220 degrees centigrade and less than or equal to 240 degrees centigrade.

13. The method of manufacturing the touch panel (10) of claim 1, further comprising:
forming a mask layer (180) on the cover plate (170), wherein the mask layer (180) is located on at least one side of the cover plate (170), or wherein the first substrate (100) comprises a plurality of regions (V) divided at intervals, and the step S3 comprises simultaneously forming a plurality of sensing layers (130) on the buffer layer (122), wherein each of the sensing layers (130) corresponds to one of the regions (V) of the first substrate (100).

14. The method of manufacturing the touch panel (10) of claim 13, wherein after the step S5, the method further comprises:
providing a third substrate (310), and the thin film layer (121) is located between the buffer layer (122) and the third substrate (310), said method preferably further comprising:
separating the regions (V) respectively corresponding to the sensing layers (130) as plural; and removing the third substrate (310).

15. The method of manufacturing the touch panel (10) of claim 1, wherein the step S1 comprises:
coating the first substrate (100) with a solution; and curing the solution to form the thin film layer (121) on the first substrate (100), wherein the solution preferably comprises soluble polyimide and organic solvents, or the solution comprises polyamic acid and organic solvents.

**Patentansprüche**

1. Verfahren zum Herstellen eines Touchpanels (10), umfassend:

S1: Ausbilden einer Dünnfilmschicht (121) auf einem ersten Substrat (100);
S2: Ausbilden einer Pufferschicht (122) auf der Dünnfilmschicht (121), wobei die Dünnfilmschicht (121) zwischen dem ersten Substrat (100) und der Pufferschicht (122) angeordnet ist;
S3: Ausbilden einer Sensorschicht (130) auf der Pufferschicht (122), wobei die Pufferschicht (122) zwischen der Dünnfilmschicht (121) und der Sensorschicht (130) angeordnet ist;
S4: Ausbilden eines zweiten Substrats (150) auf der Sensorschicht (130),
wobei die Sensorschicht (130) zwischen der Pufferschicht (122) und dem zweiten Substrat (150) angeordnet ist;
S5: Entfernen des ersten Substrats (100);
S6: Anhaften einer Deckplatte (170) auf der Dünnfilmschicht (121) durch eine Verbindungsschicht (bonding layer) (160), wobei die Verbindungsschicht (160) zwischen der Deckplatte (170) und der Dünnfilmschicht (121) angeordnet ist; und
S7: Entfernen des zweiten Substrats (150).

2. Verfahren zum Herstellen des Touchpanels (10) nach Anspruch 1, wobei im Schritt S1 die Dünnfilmschicht (121) durch eine erste Haftschicht (110) an dem ersten Substrat (100) befestigt wird, oder wobei im Schritt S2 die Pufferschicht (122) auf der Dünnfilmschicht (121) durch Übertragungsdrucken oder durch Aushärten nach Beschichten mit einer Lösung ausgebildet wird.

3. Verfahren zum Herstellen des Touchpanels (10) nach Anspruch 1, wobei zwischen dem Schritt S3 und dem Schritt S4 das Verfahren ferner Folgendes umfasst:
Ausbilden einer Schutzschicht (200) auf der Sensorschicht (130), wobei die Sensorschicht (130) zwischen der Pufferschicht (122) und der Schutzschicht (200) angeordnet ist.

4. Verfahren zum Herstellen des Touchpanels (10) nach Anspruch 3, wobei der Schritt des Ausbildens der Schutzschicht (200) Folgendes umfasst:

Ausbilden einer ersten Schutzschicht (201) auf der Sensorschicht (130), wobei die Sensorschicht (130) zwischen der Pufferschicht (122) und der ersten Schutzschicht (201) angeordnet ist; und
Ausbilden einer zweiten Schutzschicht (202) auf der ersten Schutzschicht (201), wobei die erste Schutzschicht (201) zwischen der Sensorschicht (130) und der zweiten Schutzschicht (202) angeordnet ist, wobei die Schutzschicht (200) vorzugsweise durch Übertragungsdruck oder Aushärten nach Beschichtung mit einer Lösung durchgeführt wird.

5. Verfahren zum Herstellen eines Touchpanels (10) nach Anspruch 1, wobei im Schritt S4 das zweite Substrat (150) durch eine zweite Haftschicht (140) an der Sensorschicht (130) befestigt wird, oder wobei das zweite Substrat (150) ein flexibles Substrat ist, oder wobei im Schritt S5 das erste Substrat (100) durch Einweichen in einer Lösung, Wärmebehandlung, Kältebehandlung, Abziehen durch externe Kraft oder Kombinationen derselben entfernt wird.

6. Verfahren zum Herstellen des Touchpanels (10) nach Anspruch 2, wobei das erste Substrat (100) einen zentralen Bereich und einen peripheren Bereich definiert, der den zentralen Bereich (M) umgibt, wobei die erste Haftschicht (110) in dem peripheren Bereich (N) des ersten Substrats (100) angeordnet ist, und die Sensorschicht (130) in dem zentralen Bereich (M) des ersten Substrats (100) angeordnet ist, wobei der Schritt S5 vorzugsweise Folgendes umfasst:
Schneiden entlang eines Randes des peripheren Bereichs (N) in der Nähe des zentralen Bereichs (M), um die erste Haftschicht (110) abzuschneiden, die in dem peripheren Bereich (N) angeordnet ist, und darauf Entfernen des ersten Substrats (100), oder wobei der Schritt (S5) vorzugsweise Folgendes umfasst:
Schneiden entlang eines Randes des peripheren Bereichs (N) in der Nähe des zentralen Bereichs (M), um die erste Haftschicht (110), die in dem peripheren Bereich (N) angeordnet ist und einen Teil des ersten Substrats (100) abzuschneiden, welches in dem peripheren Bereich (N) angeordnet ist, und darauf entfernen des ersten Substrats (100).

7. Verfahren zum Herstellen des Touchpanels von Anspruch 5, wobei der Schritt S7 Folgendes umfasst:
Durchführen einer Lichtbehandlung, einer Wärmebehandlung, eine Kältebehandlung oder Kombinationen derselben, auf die zweite Haftschicht (140), und darauf Entfernen der zweiten Haftschicht (140) und des zweiten Substrats (150).

8. Verfahren zum Herstellen des Touchpanels (10) nach Anspruch 1, wobei der Schritt des Ausbildens der Sensorschicht (130) Folgendes umfasst:

Ausbilden einer Mehrzahl von ersten Drähten (132), die in Intervallen entlang einer ersten Richtung angeordnet sind;
Ausbilden einer Mehrzahl von ersten Elektrodenblöcken (131), die entlang der ersten Richtung angeordnet sind, einer Mehrzahl von zweiten Elektrodenblöcken (133), die entlang einer zweiten Richtung angeordnet sind, und einer Mehrzahl von zweiten Drähten (134), wobei die ersten Elektrodenblöcke (131), die einander benachbart sind, elektrisch durch die ersten Drähte (132) verbunden sind, wobei die zweiten Elektrodenblöcke (133) auf zwei Seiten der ersten Drähte (132) angeordnet sind, und wobei die zweiten Elektrodenblöcke (133), die einander benachbart sind, elektrisch durch zweite Drähte (134) verbunden sind; und
Ausbilden einer Mehrzahl von isolierenden Blöcken (135) zwischen den ersten Drähten (132) und den zweiten Drähten (134), um die ersten Drähte (132) von den zweiten Drähten (134) elektrisch zu isolieren.

9. Verfahren zum Herstellen des Touchpanels (10) nach Anspruch 8, wobei die ersten Elektrodenblöcke (131), die zweiten Elektrodenblöcke (133), die zweiten Drähte (134) und die ersten Drähte (132) jeweils bei einer Temperatur in einem Bereich von 20°C bis 8o°C ausgebildet werden.

10. Verfahren zum Herstellen des Touchpanels (10) nach Anspruch 8, wobei nach dem Schritt des Ausbildens der ersten Drähte (132), das Verfahren ferner einen Schritt des Backens umfasst.

**11.** Verfahren zum Herstellen des Touchpanels (10) nach Anspruch 8, wobei nach dem Schritt des Ausbildens der ersten Elektrodenblöcke (131), der zweiten Elektrodenblöcke (133) und der zweiten Drähte (134) das Verfahren ferner einen Schritt des Backens umfasst.

**12.** Verfahren zum Herstellen des Touchpanels (10) nach Anspruch 10, wobei die Back-Temperatur größer oder gleich 180°C ist, und geringer oder gleich 350°C ist, vorzugsweise größer oder gleich 220°C und geringer oder gleich 240°C ist.

**13.** Verfahren zum Herstellen des Touchpanels (10) nach Anspruch 1, das ferner Folgendes umfasst: Ausbilden einer Maskenschicht (180) auf der Deckplatte (170), wobei die Maskenschicht (180) auf mindestens einer Seite der Deckplatte (170) angeordnet ist, oder wobei das erste Substrat (100) eine Mehrzahl von Bereichen (V) umfasst, die in Intervallen getrennt sind, und der Schritt S3 es umfasst, gleichzeitig eine Mehrzahl von Sensorschichten (130) auf der Pufferschicht (122) auszubilden, wobei eine jede der Sensorschichten (130) einem der Bereiche (V) auf dem ersten Substrat (100) entspricht.

**14.** Verfahren zum Herstellen des Touchpanels (10) nach Anspruch 13, wobei nach dem Schritt S5 das Verfahren ferner Folgendes umfasst: Bereitstellen eines dritten Substrats (310), wobei die Dünnfilmschicht (121) zwischen der Pufferschicht (122) und dem dritten Substrat (310) angeordnet ist, wobei das Verfahren vorzugsweise ferner Folgendes umfasst: Trennen der Bereiche (V) jeweils entsprechend den Sensorschichten (130) in eine Mehrzahl, und Entfernen des dritten Substrats (310).

**15.** Verfahren zum Herstellen des Touchpanels (10) nach Anspruch 1, wobei der Schritt S1 Folgendes umfasst: Beschichten des ersten Substrats (100) mit einer Lösung; und Aushärten der Lösung, um die Dünnfilmschicht (121) auf dem ersten Substrat (100) zu bilden, wobei die Lösung vorzugsweise lösbares Polyimid und organische Lösungsmittel umfasst, oder wobei die Lösung Polyamidsäure und organische Lösungsmittel umfasst.

**Revendications**

**1.** Procédé de fabrication d'un panneau tactile (10), comprenant:

S1 : formation d'une couche de film mince (121) sur un premier substrat (100);
S2 : formation d'une couche tampon (122) sur la couche de film mince (121), la couche de film mince (121) étant située entre le premier substrat (100) et la couche tampon (122);
S3 : formation d'une couche de détection (130) sur la couche tampon (122), la couche tampon (122) étant située entre la couche de film mince (121) et la couche de détection (130);
S4 : formation d'un deuxième substrat (150) sur la couche de détection (130), la couche de détection (130) étant située entre la couche tampon (122) et le deuxième substrat (150);
S5 : retrait du premier substrat (100);
S6 : collage d'une plaque de recouvrement (170) sur la couche de film mince (121) par une couche de liaison (160), la couche de liaison (160) étant située entre la plaque de recouvrement (170) et la couche de film mince (121); et
S7 : retrait du deuxième substrat (150).

**2.** Procédé de fabrication du panneau tactile (10) selon la revendication 1, dans lequel, à l'étape S1, la couche de film mince (121) est collée au premier substrat (100) par une première couche adhésive (110) ou dans lequel, à l'étape S2, la couche tampon (122) est formée sur la couche de film mince (121) par impression par transfert ou par durcissement après un revêtement en solution.

**3.** Procédé de fabrication du panneau tactile (10) selon la revendication 1, dans lequel, entre l'étape S3 et l'étape S4, ce procédé comprend en outre: la formation d'une couche protectrice (200) sur la couche de détection (130) et la couche de détection (130) est située entre la couche tampon (122) et la couche protectrice (200).

**4.** Procédé de fabrication du panneau tactile (10) selon la revendication 3, dans lequel l'étape de formation de la couche protectrice (200) comprend:

la formation d'une première couche protectrice (201) sur la couche de détection (130) et la couche de détection (130) est située entre la couche tampon (122) et la première couche protectrice (201); et
la formation d'une deuxième couche protectrice (202) sur la première couche protectrice (201) et la première couche protectrice (201) est située entre la couche de détection (130) et la deuxième couche protectrice (202) la couche protectrice (200) étant de préférence formée par impression par transfert ou par durcissement après un revêtement en solution.

**5.** Procédé de fabrication du panneau tactile (10) selon la revendication 1, dans lequel, à l'étape S4, le deuxième substrat (150) est collé à la couche de détection (130) par une deuxième couche adhésive (140) ou dans lequel le deuxième substrat (150) est un substrat flexible ou dans lequel, à l'étape S5, le premier substrat (100) est retiré par trempage dans une solution, traitement thermique, traitement à froid, effeuillage par une force externe ou des combinaisons de ces procédés.

**6.** Procédé de fabrication du panneau tactile (10) selon la revendication 2, dans lequel le premier substrat (100) définit une région centrale et une région périphérique entourant la région centrale (M), la première couche adhésive (110) étant située dans la région périphérique (N) du premier substrat (100), et la couche de détection (130) étant située dans la région centrale (M) du premier substrat (100), l'étape S5 comprenant de préférence:
la découpe le long d'un bord de la région périphérique (N) proximale par rapport à la région centrale (M) pour couper la première couche adhésive (110) située dans la région périphérique (N) puis le retrait du premier substrat (100), ou l'étape S5 comprenant de préférence:
la découpe le long d'un bord de la région périphérique (N) proximale par rapport à la région centrale (M) pour couper la première couche adhésive (110) située dans la région périphérique (N) et une partie du premier substrat (100) située dans la région périphérique (N) puis le retrait du premier substrat (100).

**7.** Procédé de fabrication du panneau tactile (10) selon la revendication 5, dans lequel l'étape S7 comprend:
la réalisation d'un traitement à la lumière, d'un traitement thermique, d'un traitement à froid ou des combinaisons de ces procédés sur la deuxième couche adhésive (140) puis le retrait de la deuxième couche adhésive (140) et du deuxième substrat (150).

**8.** Procédé de fabrication du panneau tactile (10) selon la revendication 1, dans lequel l'étape de formation de la couche de détection (130) comprend:

la formation d'une pluralité de premiers fils (132) disposés à des intervalles déterminés le long d'une première direction;
la formation d'une pluralité de premiers blocs d'électrodes (131) disposés le long de la première direction, d'une pluralité de deuxièmes blocs d'électrodes (133) disposés le long d'une deuxième direction et d'une pluralité de deuxièmes fils (134), les premiers blocs d'électrodes (131) adjacents entre eux étant connectés électriquement par les premiers fils (132), les deuxièmes blocs d'électrodes (133) étant répartis sur deux côtés des premiers fils (132) et les deuxièmes blocs d'électrodes (133) adjacents entre eux étant connectés électriquement par les deuxièmes fils (134); et
la formation d'une pluralité de blocs isolants (135) entre les premiers fils (132) et les deuxièmes fils (134) pour isoler électriquement les premiers fils (132) et les deuxièmes fils (134).

**9.** Procédé de fabrication du panneau tactile (10) selon la revendication 8, dans lequel les premiers blocs d'électrodes (131), les deuxièmes blocs d'électrodes (133), les deuxièmes fils (134) et les premiers fils (132) sont formés respectivement à une température de l'ordre de 20 degrés centigrades à 80 degrés centigrades.

**10.** Procédé de fabrication du panneau tactile (10) selon la revendication 8, dans lequel, après l'étape de formation des premiers fils (132), ce procédé comprend une étape de cuisson.

**11.** Procédé de fabrication du panneau tactile (10) selon la revendication 8, dans lequel, après l'étape de formation des premiers blocs d'électrodes (131), des deuxièmes blocs d'électrodes (133) et des deuxièmes fils (134), ce procédé comprend en outre une étape de cuisson.

**12.** Procédé de fabrication du panneau tactile (10) selon la revendication 10, dans lequel la température de cuisson est supérieure ou égale à 180 degrés centigrades et inférieure ou égale à 350 degrés centigrades, de préférence supérieure ou égale à 220 degrés centigrades et inférieure ou égale à 240 degrés centigrades.

**13.** Procédé de fabrication du panneau tactile (10) selon la revendication 1, comprenant en outre:
la formation d'une couche de masque (180) sur la plaque de recouvrement (170), la couche de masque (180) étant située sur au moins un côté de la plaque de recouvrement (170) ou le premier substrat (100) comprenant une pluralité de régions (V) divisées à des intervalles déterminés et l'étape S3 comprend la formation simultanée d'une pluralité de couches de détection (130) sur la couche tampon (122), chacune des couches de détection (130) correspondant à une des régions (V) du premier substrat (100).

**14.** Procédé de fabrication du panneau tactile (10) selon la revendication 13, dans lequel, après l'étape S5, ce procédé comprend en outre:
la fourniture d'un troisième substrat (310), et la couche de film mince (121) est située entre la couche tampon (122) et le troisième substrat (310), ledit procédé comprenant en outre de préférence:
la séparation des régions (V) correspondant respectivement aux couches de détection (130) ; et le retrait du troisième substrat (310).

**15.** Procédé de fabrication du panneau tactile (10) selon la revendication 1, dans lequel l'étape S1 comprend: le revêtement du premier substrat (100) avec une solution, et le durcissement de la solution pour former la couche de film mince (121) sur le premier substrat (100), la solution comprenant de préférence du polyimide soluble et des solvants organiques ou la solution comprenant de l'acide polyamique et des solvants organiques.

1A

1B

1C

1D

1E-1

1E-2

1F

1G

10

170

180

160

120 { 121

122

180

130

1H

N | M | N

150
140
200
130
120 { 122
121
110

100

2A

20

170
180
180
160
120 { 121
122
200 { 201
130
202

2B

3A

图 3B

3C

V V V

30

3D

130

131 132 134 133 135 136

136

4

**EP 3 051 392 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040183958 A1